## Europäisches Patentamt
## European Patent Office
## Office européen des brevets

(19)

(11) Veröffentlichungsnummer: **0 159 617**
**B1**

(12) **EUROPÄISCHE PATENTSCHRIFT**

(45) Veröffentlichungstag der Patentschrift:
24.02.88

(21) Anmeldenummer: **85104313.3**

(22) Anmeldetag: **10.04.85**

(51) Int. Cl.⁴: **H 01 L 21/00,** H 01 L 21/265, H 01 L 21/285, H 01 L 29/08

(54) Verfahren zum Herstellen von hochintegrierten MOS-Feldeffekttransistoren.

(30) Priorität: **19.04.84 DE 3415002**

(43) Veröffentlichungstag der Anmeldung:
**30.10.85 Patentblatt 85/44**

(45) Bekanntmachung des Hinweises auf die Patenterteilung:
**24.02.88 Patentblatt 88/8**

(84) Benannte Vertragsstaaten:
**AT CH DE FR GB IT LI NL SE**

(56) Entgegenhaltungen:
**EP-A-0 035 598**
**EP-A-0 054 117**
**EP-A-0 081 999**
**EP-A-0 090 318**
**US-A-4 204 894**
**US-A-4 356 623**

(73) Patentinhaber: **Siemens Aktiengesellschaft Berlin und München, Wittelsbacherplatz 2, D-8000 München 2 (DE)**

(72) Erfinder: **Schwabe, Ulrich, Dr., Plievierpark 14, D-8000 München 83 (DE)**
Erfinder: **Jacobs, Erwin P., Dr., Millöckerstrasse 76, D-8011 Vaterstetten (DE)**
Erfinder: **Neppl, Franz, Dr., St.- Quirin- Platz 6, D-8000 München 90 (DE)**

## Beschreibung

Die Erfindung betrifft ein Verfahren zum Herstellen von hochintegrierten MOS-Feldeffekttransistoren, bei dem die Herstellung der Source/Drain-Bereiche durch Ionenimplantation nach dem Erzeugen der Gate-Elektrode unter Verwendung der Gate-Elektrode als Implantationsmaske vorgenommen wird und bei dem die Source/Drain-Ionenimplantation durch eine an den Gateflanken zusätzlich erzeugte Oxidschicht (spacer oxide) abgeschirmt und dadurch die Unterdiffusion der implantierten Source/Drain-Bereiche unter die Gate-Elektrodenfläche vermindert wird.

MOS-Prozesse in VLSI-Technik ( = very large scale integration) werden benützt, um Bauelemente in hoher Packungsdichte und mit großen Schaltgeschwindigkeiten herzustellen. Neben parasitären Leitungskapazitäten spielen die parasitären Kapazitäten in den Transistoren selbst eine große Rolle, da sie eine Begrenzung für die erreichbaren Gatterlaufzeiten darstellen. Die laterale Ausdiffusion der hochdotierten Source/Drain-Bereiche in Gebiete unterhalb der Transistorgates führt zu einer wesentlichen Erhöhung der sogenannten Miller-Kapazität zwischen Gate- und Diffusionsgebieten.

Die Unterdiffusion der MOS-Transistor-Gates wird bekannterweise durch ein Zurückziehen (pull back) der Implantationskante von der Gatekante zu verhindern versucht. So ist in der Patentanmeldung gemäß EP-A- 0 123 182 ein Verfahren der eingangs genannten Art beschrieben, bei dem vor der Source/Drain-Implantation ein spacer oxide durch Reoxidation des Polysilizium-Gates gebildet wird. Die dazu erforderlichen Temperaturen liegen bei 900° C und darüber, die Oxidationszeiten bei 2 bis 3 Stunden. Diese Temperaturbelastung ist für die bereits erzeugten Bauelementstrukturen schädlich.

Ein weiteres Verfahren der eingangs genannten Art, bei dem über eine Oxidschicht an den Flanken des Transistorgates ein Abstand zwischen Gate und Kante der Source/Drain-Ionen-Implantation (S/D-pull back mittels sidewall-oxide spacer) eingestellt wird, ist aus einem Aufsatz von Tsang et al aus den IEEE Trans. Electr. Dev., ED-29 (1982), auf den Seiten 590 bis 596, zu entnehmen. Bei diesem Verfahren muß die abgeschiedene spacer-oxide-Schicht vor der Source/Drain-Implantation anisotrop geätzt werden.

Schließlich ist aus einem Aufsatz von Ogura et al, IEEE Trans. Electr. Dev., ED-27 (1980), Seiten 1359 bis 1367 ein weiteres Verfahren zur Verminderung der Unterdiffusion unter die Gatefläche von MOS-Transistoren bekannt, bei dem die Source/Drain-Implantation mittels der Polysilizium-Gate-Elektrode als Maske durchgeführt wird und anschließend das Polysilizium-Gate überätzt wird. Ätzprozesse sind in der VLSI-Technologie kritische Fertigungsschritte und sollen nach Möglichkeit vermieden werden.

Die Aufgabe, die der Erfindung zugrundeliegt, besteht in der Durchführung eines MOS-Prozesses der eingangs genannten Art, bei dem die bei den eben geschilderten Verfahren auftretenden Nachteile vermieden werden und die Herstellung der gewünschten Schaltung mit möglichst wenigen maskenaufwendigen Prozeßschritten durchführbar ist. Außerdem sollen steile Stufen auf der Halbleiteroberfläche eingeebnet werden.

Diese Aufgabe wird erfindungsgemäß dadurch gelöst, daß als Gatekantenmaskierung für die Source/Drain-Ionen-Implantation nach der Strukturierung der Gate-Elektrode ganzflächig eine leicht fließende Silikatglasschicht durch Abscheidung aus der Gasphase (CVD = chemical vapor deposition) in einer Schichtdicke aufgebracht wird, die so eingestellt wird, daß die Dotierstoff-Ionen bei der nachfolgenden Source/Drain-Implantation in die oberflächennahe Zone unter der Silikatglasschicht gerade noch implantiert werden, eine Ionenimplantation in die Zonen an den Gate-Kanten aber unterbleibt.

Das erfindungsgemäße Verfahren unterscheidet sich von den bekannten Verfahren durch die Art des Oxids und die dabei auftretende Temperaturbelastung, sowie durch den Wegfall einer notwendigen Oxidätzung.

Es ist vorteilhaft, als leicht fließendes Silikatglas das in einem Aufsatz von Kern und Schnable im RCA Review 43 (1982) auf den Seiten 423 bis 457 beschriebene, als Zwischenoxid dienende Bor-Phosphor-Silikatglas (BPSG) zu verwenden. Es kann aber auch Phosphor-Silikatglas oder ein anderes, aus der Gasphase abgeschiedenes Oxid verwendet werden.

Während die Dicke der Silikatglasschicht auf einen Wert eingestellt wird, bei dem die Source/Drain-Ionen-Implantation mit dem vorgesehenen Implantationsstoff (dopant) in die oberflächennahe Zone unter dem Silikatglas in den gatekantenfernen Gebieten gerade noch durchgeführt werden kann, erhält man nach der CVD-Abscheidung relativ steile Oxidflanken an der Seitenfläche der Gate-Elektrode mit einer großen Schichtdicke, die bei der Implantation als Maske wirkt. Die nach der Implantation folgende Temperaturbehandlung, die bei Temperaturen unterhalb 900° C durchgeführt werden kann, dient zum Verfließen und Verrunden der Kanten sowie zur Ausheilung der Ionenimplantation.

Das nach der Ausheilung entstandene Dotierungsprofil ist relativ steil und entspricht einem stufenförmigen p/n-Übergang.

Das erfindungsgemäße Verfahren kann aber auch so durch geführt werden, daß vor der Source/Drain-Ionen-Implantation die Silikatglasschicht durch eine Temperaturbehandlung bei T kleiner 900° C zum Verfließen gebracht wird und die Schichtdicke bei der Abscheidung so eingestellt wird, daß in Abstimmung mit der Temperaturbehandlung die Glasschicht an den Flanken des Gates beim nachfolgenden S/D-Implantationsschritt bis zu einem bestimmten Abstand vom Gate als Maske wirkt, dann aber kontinuierlich ihre maskierende Wirkung verliert und im kantenfernen Gebiet gerade noch so dick ist, daß die Dotierstoff-Ionen in die oberflächennahe Zone unter die Silikatglasschicht implantiert werden. An den Kanten des Gates treten starke Verrundungen und an den Seitenfläche schräge Flanken auf.

Vorteilhaft ist, daß das Verfahren nicht nur für Polysilizium sondern auch für nicht-oxidierbare Gatematerialien, wie zum Beispiel Silizide hochschmelzender Metalle (refractory metals) verwendbar ist.

Weitere Ausgestaltungen der Erfindung sind aus den Unteransprüchen zu entnehmen.

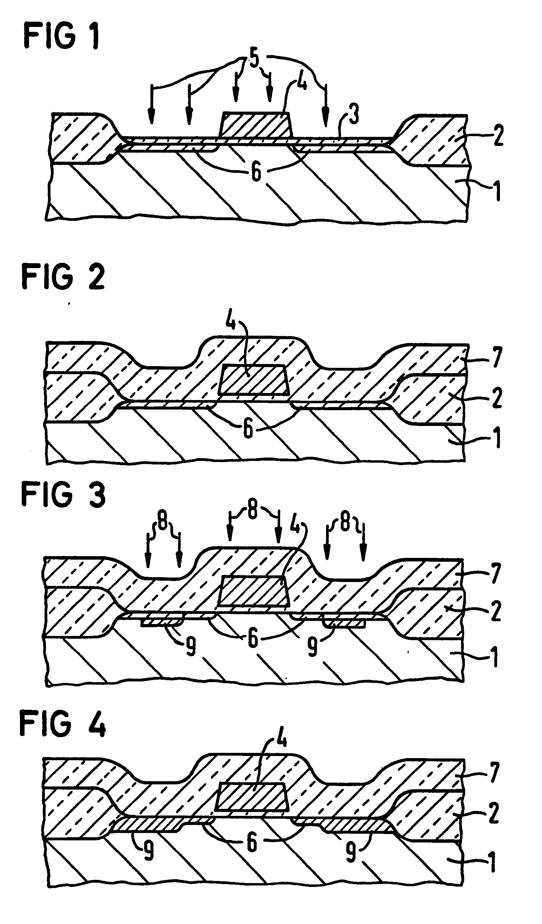

Nähere Einzelheiten werden nachfolgend anhand von Ausführungsbeispielen und der Figuren 1 bis 7, welche im Schnittbild die erfindungswesentlichen Verfahrensschritte darstellen, beschrieben. Es wird der Prozeßablauf zur Herstellung von n-Kanal-MOS-Transistoren beschrieben. Das erfindungsgemäße Verfahren ist aber auch für die Herstellung von p-Kanal-MOS-Transistoren und auch auf CMOS-Prozesse anwendbar. In allen Figuren gelten für gleiche Teile gleiche Bezugszeichen.

Die Prozeßschritte bis zur Strukturierung des aus polykristallinem Silizium bestehenden Gates entsprechen bekannten Prozeßabläufen. Die weiteren, zum Teil erfindungswesentlichen Prozeßschritte (Figur 1 bis 7) sind verschieden zusammensetzbar.

Figur 1: In einem aus p-dotiertem Silizium bestehendem Substrat 1, in welchen die aktiven Transistorzonen durch Feldoxidbereiche 2 getrennt sind und auf welchen das Gateoxid 3 in einer Schichtdicke von ~ 20 nm erzeugt ist, wird nach Strukturierung der aus Polysilizium bestehenden Gate-Elektrode 4 eine Implantation mit Arsen-Ionen (siehe Pfeile 5) mit einer Dosis und Energie von 4 x 10$^{15}$ cm$^{-2}$ und 40 keV zur Herstellung einer flachen 5 Anschlußdiffusionszone 6 durchgeführt.

Figur 2: Dann wird ganzflächig durch einen CVD-Prozeß bei 400 bis 450° C eine aus Bor-Phosphor-Silikatglas bestehende Schicht 7 in einer Schichtdicke von 100 nm aufgebracht. Die Gateoxidschicht 3 ist ab Figur 3 der besseren Übersicht wegen nicht mehr eingezeichnet.

Figur 3: Es erfolgt nun in einer ersten Variante des erfindungsgemäßen Verfahrens die Source/Drain-Implantation mit Phosphor-Ionen (siehe Pfeile 8) zur Erzeugung der Source/Drain-Zonen 9 mit einer Dosis und Energie von 6 x 10$^{15}$ cm$^{-2}$ und 100 keV.

Figur 4: Nach erfolgter Temperaturbehandlung (Flow Prozeß) bei 800 bis 900° C, wobei das BPSG 7 zum Verfließen gebracht und die Ionen-Implantation 8 ausgeheilt wird, ergibt sich die in Figur 4 dargestellte Struktur mit über der Gate-Elektrode 4 verrundeten Kanten der BPSG-Schicht 7. Das Dotierungsprofil ist relativ steil und entspricht einem stufenförmigen p/n-Übergang (1, 6, 9).

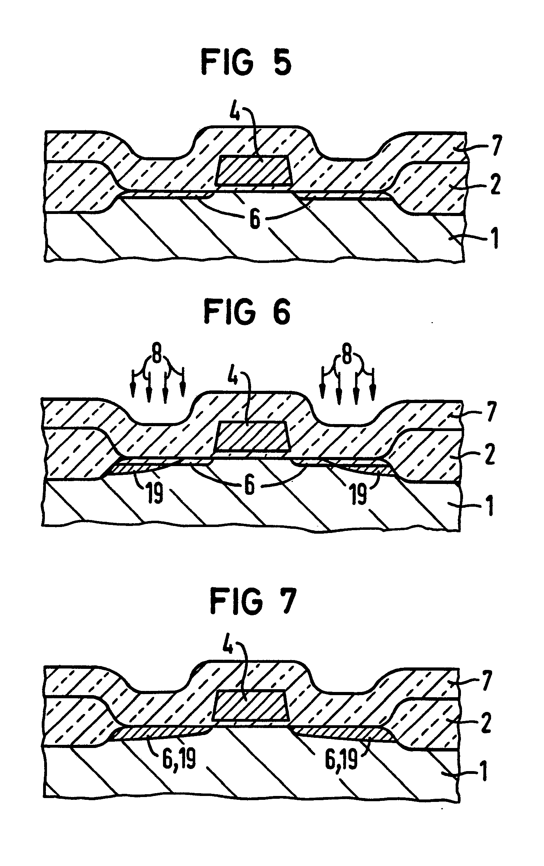

Figur 5: In einer zweiten Variante des erfindungsgemäßen Verfahrens wird nach dem Erzeugen der Anschlußdiffusionszone 6 (nach Figur 1) und nach dem Aufbringen der BPSG-Schicht 7 (nach Figur 2) vor der Source/Drain-Ionen-Implantation der Flow-Prozeß 800 bis 900° C durchgeführt. An den Kanten des Gates 4 treten starke Verrundungen und an den Seitenflächen schräge Flanken auf. Durch bestimmte Auswahl der Schichtdicke in Abstimmung auf die Tempertemperatur ist das "verflossene" BPSG 7 an den Flanken des Gates 4 so dick, daß es im nachfolgenden Source/Drain-Implantationsschritt für einen gewünschten Abstand zum Gate 4 als Maske wirkt, dann aber kontinuierlich seine maskierende Wirkung verliert und im kantenfernen Gebiet gerade so dick ist, daß die implantierten Ionen in das erwünschte Halbleitergebiet (1) unterhalb der BPSG-Isolationsschicht 7 gelangen.

Figur 6 zeigt die Erzeugung der Source/Drain-Zone 19 durch eine Phosphor-Ionen-Implantation (siehe Pfeile 8) bei einer Dosis und Energie von 6 x 10$^{15}$ cm$^{-2}$ und 100 keV.

Figur 7: Durch die nachfolgende Ausheilung der Ionen-Implantation 8 entsteht ein abgeschrägtes Dotierprofil, welches einer "graded junction" im p/n-Übergang (1, 6, 9) entspricht. Diese form des Profils trägt wesentlich zur Durchbruchsspannungssicherheit der n-Kanal-Transistoren bei.

Im Anschluß an den in Figur 4 bzw. Figur 7 beschriebenen Prozeßschritt wird das Zwischenoxid, welches ebenfalls aus BPSG bestehen kann, in einer Schichtdicke von ~ 500 nm abgeschieden und die Anordnung wahlweise einem weiteren flow-Prozeß unterworfen. Die Kontaktierung erfolgt in bekannter Weise.

**Patentansprüche**

1. Verfahren zum Herstellen von hochintegrierten MOS-Feldeffekttransistoren, bei dem die Herstellung der Source/ Drain-Bereiche (9, 19) durch Ionen-Implantation nach dem Erzeugen der Gate-Elektrode (4) unter Verwendung einer Gate-Elektrode (4) als Implantationsmaske vorgenommen wird und bei dem die Source/Drain-Ionen-Implantation (8) durch eine an den Gateflanken zusätzlich erzeugte Oxidschicht (spacer oxide) abgeschirmt und dadurch die Unterdiffusion der implantierten Source/Drain-Bereiche (9, 19) unter die Gate-Elektrodenfläche (4) vermindert wird, dadurch gekennzeichnet , daß als Gate-Kantenmaskierung für die Source/Drain-Ionen-Implantation (8) nach der Strukturierung der Gate-Elektrode (4) ganzflächig eine leicht fließende Silikatglasschicht (7) durch Abscheidung aus der Gasphase (CVD) in einer Schichtdicke aufgebracht wird, die so eingestellt wird, daß die Dotierstoff-Ionen bei der nachfolgenden

Source/Drain-Ionen-Implantation (8) in die oberflächennahe Zone des Substrats (1) unter der Silikatglasschicht (7) gerade noch implantiert werden, eine Ionenimplantation in dia Zonen an den Gate-Kanten (4) aber unterbleibt.

2. Verfahren nach Anspruch 1, <u>dadurch gekennzeichnet</u>, daß die Silikatglasschicht (7) durch eine Temperaturbehandlung bei T kleiner 900° C zum Verfließen gebracht wird, und die Schichtdicke bei der Abscheidung so eingestellt wird, daß in Abstimmung mit der Temperaturbehandlung die Silikatglasschicht (7) an den flanken des Gates (4) beim nachfolgenden Source/Drain-Implantationsschritt (8) bis zu einem bestimmten Abstand vom Gate als Maske wirkt, dann aber kontinuierlich ihre maskierende Wirkung verliert und im kantenfernen Gebiet gerade noch so dick ist, daß die Dotierstoff-Ionen in die oberflächennahe Zone des Substrats (1) unter die Silikatglasschicht (7) gerade noch implantiert werden.

3. Verfahren nach Anspruch 1 oder 2, <u>dadurch gekennzeichnet</u> , daß als Material für die Gate-Elektrode (4) Polysilizium oder ein Silizid hochschmelzender Metalle (refractory metals) verwendet wird.

4. Verfahren nach Anspruch 3, <u>dadurch gekennzeichnet</u>, daß Tantalsilizid (TaSi$_2$) verwendet wird.

5. Verfahren nach einem der Ansprüche 1 bis 4, <u>dadurch gekennzeichnet</u>, daß als Silikatglasschicht (7) eine Bor-Phosphor-Silikatglasschicht (BPSG) oder eine Phosphor-Silikatglasschicht (PSG) oder ein anderes, aus der Gasphase abgeschiedenes SiO$_2$ verwendet wird.

6. Verfahren nach einem der Ansprüche 1 bis 5, <u>dadurch gekennzeichnet</u> , daß vor der Abscheidung der das Gate (4) bedeckenden Silikatglasschicht (7) bei n-Kanaltransistoren eine Ionen-Implantation (5) zur Herstellung einer flachen Source/Drain-Anschlußdiffusionszone (6) durchgeführt wird.

7. Verfahren nach Anspruch 6, <u>dadurch gekennzeichnet</u>, daß die Ionen-Implantation mit Arsen-Ionen (5) durchgeführt wird.

8. Verfahren nach einem der Ansprüche 1 bis 7, <u>dadurch gekennzeichnet</u> , daß bei Verwendung einer Bor-Phosphor-Silikatglasschicht (7) zur Kanten-Maskierung die Schichtdicke im Bereich von 100 nm eingestellt wird.

9. Verfahren nach einem der Ansprüche 1 bis 8, <u>dadurch gekennzeichnet</u> , daß die Temperaturbehandlung vor und/oder nach der Source/Drain-Ionen-Implantation (8) in einem Temperaturbereich zwischen 800 bis 900° C durchgeführt wird.

10. Verfahren nach einem der Ansprüche 1 bis 9, <u>dadurch gekennzeichnet</u>, daß die Ionenimplantation (8) durch die Glasschicht (7) mit Phosphor-Ionen durchgeführt wird.

11. Verfahren nach einem der Ansprüche 1 bis 10 gekennzeichnet durch Herstellung von n-Kanal- und/oder p-Kanal-MOS-Transistoren enthaltenden integrierten Schaltungen in VLSI-Technik.

## Claims

1. A process for the production of highly integrated MOS field effect transistors, in which the source/drain zones (9, 19) are formed by ion implantation after the production of the gate electrode (4) using a gate electrode (4) as implantation mask, and in which the source/drain ion implantation (8) is screened by an oxide layer (spacer oxide) additionally formed at the sidewalls of the gate, whereby diffusion of the implanted source/drain zones (9, 19) below the gate electrode surface (4) is prevented, <u>characterised in</u> that as a mask for the gate edges for the source/drain ion implantation (8), after the structuring of the gate electrode (4) a readily flowing silicate glass layer (7) is applied to the entire surface by deposition from the gas phase (CVD) in a thickness such that during the subsequent source/drain ion implantation (8), the dopant ions are still implanted into that region of the substrate (1) which is close to the surface below the silicate glass layer, whilst no ion implantation takes place into the zones at the gate edges (4).

2. A process as claimed in Claim 1, <u>characterised in</u> that the silicate glass layer (7) is caused to flow by a heat treatment at temperatures of less than 900° C and during deposition, the layer thickness is set to be such that in co-ordination with the heat treatment, during the subsequent source/drain implantation step (8), at the flanks of the gates of the gate (4), the silicate glass layer (7) serves as a mask up to a specific distance from the gate, but then continuously loses its masking effect and in the region remote from the edge, its thickness is such that the dopant ions are still implanted under the silicate glass layer (7) into that zone of the substrate (1) which is close to the surface.

3. A process as claimed in Claim 1 or 2, <u>characterised</u> in that polysilicon or a refractory metal silicide is used as the material of the gate electrode (4).

4. A process as claimed in Claim 3, <u>characterised in</u> that tantalum silicide (TaSi$_2$) is used.

5. A process as claimed in one of Claims 1 to 4, <u>characterised in</u> that a boron-phosphorus-silicate glass layer (BPSG) or a phosphorus-silicate glass layer (PSG) or another SiO$_2$ deposited from the gas phase, is used as the silicate glass layer (7).

6. A process as claimed in one of Claims 1 to 5, <u>characterised in</u> that prior to the deposition of the silicate glass layer (7) which covers the gate (4), in the case of n-channel transistors an ion implantation step (5) is carried out in order to form a flat source/drain terminal diffusion zone (6).

7. A process as claimed in Claim 6, <u>characterised in</u> that the ion implantation is carried out using arsenic ions (5).

8. A process as claimed in one of Claims 1 to 7, <u>characterised in</u> that when a boron-phosphorus-silicate glass layer (7) is used for the edge masking, the thickness of the layer is set in the region of 100 nm.

9. A process as claimed in one of Claims 1 to 8, <u>characterised in</u> that the heat treatment prior to and/or after the source/drain ion implantation (8) is carried out within a temperature range of 800 to 900° C.

10. A process as claimed in one of Claims 1 to 9, <u>characterised in</u> that the ion implantation (8) through the glass layer (7) is carried out using phosphorus ions.

11. A process as claimed in one of Claims 1 to 10, <u>characterised by</u> the production of integrated circuits containing n-channel and/or p-channel MOS-transistors, using VLSI-technology.


## Revendications

1. Procédé pour fabriquer des transistors à effet de champ MOS à haute densité d'inrégration, selon lequel on réalise la fabrication des régions de source/drain (9, 19) par implantation ionique après avoir réalisé l'électrode de grille (4), moyennant l'utilisation de cette électrode (4) en tant que masque d'implantation, et selon lequel une protection vis-à-vis de l'implantation ionique (8) de formation de la source/du drain est réalisée au moyen d'une couche d'oxyde (spacer oxide) produite de façon supplémentaire sur les flancs de la grille et, de ce fait, la diffusion sous-jacente des zones de source/drain (9, 19) réalisées par implantation, au-dessous de la surface de l'électrode de grille (4) est réduite, caractérisé par le fait qu'on dépose sur toute la surface, par dépôt à partir de la phase gazeuse (CVD), en tant qu'élément de masquage des bords de la grille pour l'implation ionique (8) de formation de la source/du drain, après structuration de l'électrode de grille (4), une couche (7) de verre aux silicates très fluide sur une épaisseur de couche qui est réglée de telle sorte que lors de l'implantation ionique ultérieure (8) de formation de la source/du drain, les ions de la substance dopante sont encore précisément implantés dans la zone du substrat (1), proche de la surface, au-dessous de la couche (7) de verre aux silicates, mais qu'aucune implantation ionique n'intervient dans les zones proches des bords de la grille (4).

2. Procédé suivant la revendication 1, caractérisé par le fait qu'on dépose la couche (7) de verre aux silicates en exécutant un traitement thermique à une température T inférieure à 900° C pour la rendre fluide et qu'on régle l'épaisseur de couche lors du dépôt de manière qu'en accord avec le traitement thermique, la couche (7) de verre aux silicates agit, au niveau des flancs de la grille (4), lors de l'étape ultérieure (8) d'implantation de la source/du drain, en tant que masque jusqu'à une distance déterminée de la grille, mais perd ensuite d'une manière permanente son effet de masquage et possède encore précisément une épaisseur telle, dans la région éloignée des bords, que les ions de la substance dopante sont encore précisément implantés dans la zone du substrat (1), proche de la surface, au-dessous de la couche (7) de verre aux silicates.

3. Procédé suivant la revendication 1 ou 2, caractérisé par le fait qu'on utilise comme matériau pour l'électrode de grille (4), du polysilicium ou un siliciure de métaux à point de fusion élevé (métaux réfractaires).

4. Procédé suivant la revendication 3, caractérisé par le fait qu'on utilise du siliciure de tantale ($TaSi_2$).

5. Procédé suivant l'une des revendications 1 à 4, caractérisé par le fait qu'on utilise comme couche (7) de verre aux silicates, une couche de verre aux silicates de bore et de phosphore (BPSG) ou une couche de verre aux silicates de phosphore (PSG) ou un autre $SiO_2$ déposé à partir de la phase gazeuse.

6. Procédé suivant l'une des revendications 1 à 5, caractérisé par le fait qu'avant le dépôt de la couche (7) de verre aux silicates, recouvrant la grille (4), on réalise, dans le cas de transistors à canal n, une implantation ionique (5) pour fabriquer une zone plate diffusée (6) de raccordement de la source/du drain.

7. Procédé suivant la revendication 6, caractérisé par le fait qu'on réalise l'implantation ionique avec des ions d'arsenic (5).

8. Procédé suivant l'une des revendications 1 à 7, caractérisé par le fait que dans le cas de l'utilisation d'une couche (7) de verre aux silicates de bore et de phosphore pour réaliser le masquage des bords, on régle l'épaisseur de couche au voisinage de 100 nm.

9. Procédé suivant l'une des revendications 1 à 8, caractérisé par le fait qu'on exécute le traitement thermique avant et/ou après l'implantation ionique (8) servant à former la source/le drain, dans une plage de températures comprises entré 800 et 900° C.

10. Procédé suivant l'une des revendications 1 à 9, caractérisé par le fait que l'implantation ionique (8) est réalisée à travers la couche de verre (7), avec des ions de phosphore.

11. Procédé suivant l'une des revendications 1 à 10, caractérisé par la fabrication de circuits intégrés contenant des transistors MOS à canal n et/ou des transistors MOS à canal p, selon la technique VLSI à très haute densité d'intégration.

**FIG 1**

**FIG 2**

**FIG 3**

**FIG 4**

## FIG 5

## FIG 6

## FIG 7